Europäisches Patentamt

European Patent Office

Office européen des brevets

(11) Publication number: 0 183 473
A2

# (12) EUROPEAN PATENT APPLICATION

(21) Application number: 85308420.0

(22) Date of filing: 19.11.85

(51) Int. Cl.⁴: H 01 S 3/19

(30) Priority: 19.11.84 JP 245818/84
20.11.84 JP 246664/84

(43) Date of publication of application:
04.06.86 Bulletin 86/23

(84) Designated Contracting States:
DE GB NL

(71) Applicant: SHARP KABUSHIKI KAISHA
22-22 Nagaike-cho Abeno-ku
Osaka 545(JP)

(72) Inventor: Yamamoto, Saburo
1-2-11, Akanedai Haibara-cho
Uda-gun Nara-ken(JP)

(74) Representative: White, Martin David et al,
Marks & Clerk 57/60 Lincoln's Inn Fields
London WC2A 3LS(GB)

(54) Semiconductor laser devices.

(57) A semiconductor laser device comprising a striped laser-operation area (1), a light emitting diode area (2) disposed parallel to said striped laser-operation area (1), an optical waveguide (3) attaining an optical coupling between said laser-operation area (1) and said light emitting area (2), and a means (4, 12, 13, 111, 222) for independently supplying electric current to said laser-operation area (1) and said light emitting area (2).

FIG.1A.

FIG.1B.

FIG.1C.

Croydon Printing Company Ltd.

## BACKGROUND OF THE INVENTION

1. Field of the invention:

This invention relates to semiconductor laser devices which produce laser light at a desired threshold current level with a desired oscillation wavelength and spectrum width (i.e., coherent length) by controlling the electric current to be injected thereinto.

2. Description of the prior art:

A significant advancement in the technology of semiconductor laser devices has shown satisfactory development in areas such as the threshold current, the transverse mode, the longitudinal mode, reliability, etc. However, the operation characteristics of these conventional semiconductor laser devices are simply determined by the structure of a built-in laser operation area and the crystal composition including the active layer, so that they cannot be controlled. On the other hand, semiconductor laser devices have been developed as information processing light sources or optical communication light sources of optical discs, etc. If the operation characteristics of these semiconductor laser devices can be controlled by a variation in electric voltage or electric current to be injected thereinto, the individual operation characteristics among these devices will be made uniform and these devices will be used as a modulator for analog signal processing or optical communication, so that the application field of semiconductor laser devices can be enlarged.

Conventional semiconductor laser devices cannot produce laser light with a controlled spectrum width (i.e., laser light with a coherent length). When these semiconductor laser devices are used in optical combination with other optical devices, a reflected light (i.e., backlight) from these optical devices is incident upon the laser devices, resulting in optical output noise. This noise is a great obstacle for analog communication systems and/or optical video discs to which analog signals resulting from optical signals through analog processing must be adapted.

An approach for the prevention of noise derived from backlight is to make the coherent length of the laser light shorter than the resonation length (5 cm or more) of a resonator which is composed of the semiconductor laser devices and the optical devices. However, it is difficult to produce semiconductor laser devices which produce laser light with a coherent length of several cm or less in a high yield. Although self-pulsation semiconductor laser devices are known as semiconductor laser devices producing laser light with such a coherent length, strict layer thickness control is required for the production of the laser devices, so that the production yield thereof is extremely low.

## SUMMARY OF THE INVENTION

The semiconductor laser device of this invention which overcomes the above-discussed and numerous other disadvantages and deficiencies of the prior art, comprises a striped laser-operation area, a light emitting diode area disposed parallel to said striped laser-operation area, an optical waveguide attaining an optical coupling between said laser-operation area and said light emitting area, and a means for independently supplying electric current to said laser-operation area and said light emitting area.

The light emitting diode area is, in one preferred embodiment, continuous. Alternatively, the light emitting diode area is, in another preferred embodiment, composed of plural parts arranged at regular intervals.

The current supplying means are, in one preferred embodiment, composed of an electrode, which is electrically separated into two parts, and electrical current paths, which are disposed in a substrate for multiple crystal growth. Alternatively, the electrode is, in another preferred embodiment, separated into two parts by a groove disposed at a position corresponding to the center between said laser operation area and said light emitting diode area. Alternatively, the electrical current paths are, in another preferred embodiment, V-channels disposed in the portions of the substrate corresponding to said laser operation area and said light emitting diode area, respectively.

Thus, the invention described herein makes possible the objects of (1) providing a semiconductor laser device which can attain control of oscillation wavelengths, threshold current, oscillation spectrum widths, etc., so that the device can be used as light sources for AM modulation, FM modulation and/or heterodyne modulation for optical information processing and/or optical communication and moreover the device can be used as a switching element in digital circuits, etc.; (2) providing a semiconductor laser device which produces laser light having a coherent length ranging from several mm to several cm by the control of electric current injected thereinto thereby preventing optical output noise derived from backlight; and (3) providing a semiconductor laser device, oscillating laser light with a coherent length of 10 mm or less, which can be produced in a high yield.


## BRIEF DESCRIPTION OF THE DRAWINGS

This invention may be better understood and its numerous objects and advantages will become apparent to those skilled in the art by reference to the accompanying drawings as follows:

Figure 1(A) is a plan view showing one semiconductor laser device of this invention;

Figure 1(B) is a sectional view on line X-X' of the semiconductor laser device shown in Figure 1(A);

Figure 1(C) is a front view of the semiconductor laser device shown in Figure 1(A);

Figure 2(A) is a graph showing the dependence of threshold current $I_{th}$ on current $I_2$ in the semiconductor laser device shown in Figure 1(A);

Figure 2(B) is a graph showing the dependence of oscillation wavelength $\lambda$ on current $I_2$ in the semiconductor laser device shown in Figure 1(A);

Figure 2(C) is a graph showing the dependence of spectrum width $\Delta f$ on current $I_2$ in the semiconductor laser device shown in Figure 1(A);

Figure 3(A) is a plan view showing another semiconductor laser device of this invention;

- 5 -

0183473

Figure 3(B) is a sectional view on line Y-Y' of the semiconductor laser device shown in Figure 3(A);

Figure 3(C) is a sectional view on line Z-Z' of the semiconductor laser device shown in Figure 3(A); and

Figure 4 is a graph showing the dependence of coherent length Lc on current $I_2$ of the semiconductor laser device shown in Figure 3(A).

DESCRIPTION OF THE PREFERRED EMBODIMENTS

(Example 1)

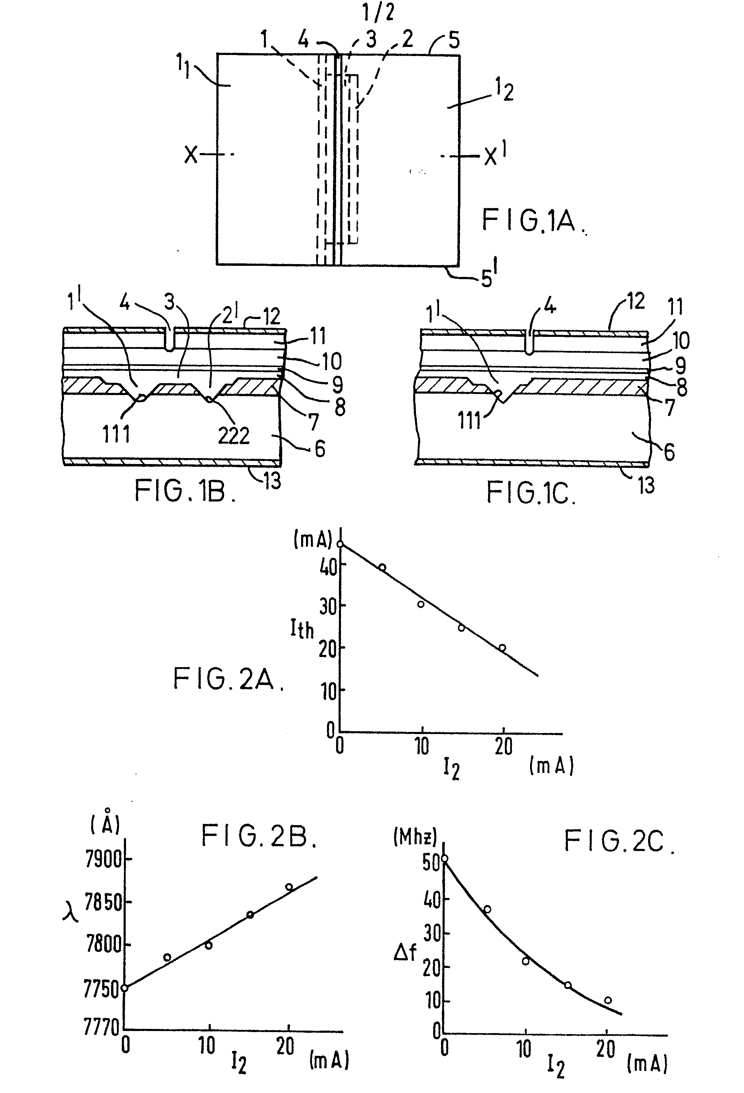

Figures 1(A), (B) and (C) show the VSIS (V-channeled substrate inner stripe) semiconductor laser device of a double heterostructure type of this invention, which comprises a striped laser operation area 1, a continuous light-emitting-diode area 2 disposed parallel to the laser operation area 1, and an optical waveguide 3 which optically couples the light emitting diode area 2 with the laser operation area 1. The laser operation area 1 and the light emitting diode area 2 are electrically separated by a striped channel 4 which is formed along the laser operation area 1 on the side containing the electrode 12, so that they independently operate when electric currents $I_1$ and $I_2$ are injected into the device. The laser operation area 1 has cleavage facets 5 and 5', whereas the light emitting diode area 2 has no cleavage facets so that it cannot attain laser oscillation therefrom. Figure 1(B) shows a sectional view on line X-X' of the portion of the semiconductor laser device shown in Figure 1(A) which attains an optical coupling between the laser operation area 1 and the light emitting diode area 2. Figure 1(C) is a front view showing the facets 5 and 5' of the semiconductor laser device shown in Figure 1(A). This semiconductor laser device is composed of a substrate 6 for multiple crystal growth, a current blocking layer 7 for the formation of a striped structure, a first cladding layer 8, an active layer 9, a second cladding layer 10, an ohmic contact layer 11, an n-side electrode 12 and a p-side electrode 13.

When electric current is injected into the device through the electrodes 12 and 13, it flows into the active layer 9 through channels 111 and 222, both of which are formed in the substrate 6. Since the active layer 9 is designed to be sandwiched between the heterojunctional interfaces of the first cladding layer 8 and the second cladding layer 10, it produces laser light based on the electric current (carrier) injected into the heteroinjunctions.

The current $I_2$ is allowed to flow into the light emitting diode area 2, resulting in laser light within the portion of the active layer 9 corresponding to the light emitting diode area 2, and at the same time the current $I_1$ is allowed to flow into the laser operation area 1, resulting in laser oscillation in the laser operation area 1. The light produced in the light emitting diode area 2 is introduced into the portion of the active layer 9 corresponding to the laser operation area 1 through the optical waveguide 3. The density of the light to be introduced into the laser operation area 1 is proportional to the current $I_2$. Thus, the laser oscillation operation characteristics (i.e., the threshold current level, the oscillation wavelength and the spectrum width) of the laser operation area 1 vary depending upon the current $I_2$. When the current $I_2$ is increased, the threshold current level of the laser operation area 1 becomes lower, the oscillation wavelength becomes longer and the spectrum width becomes smaller. These phenomena arise because laser oscillation in the laser operation area 1 results from light based on not only carrier current injected into the laser operation area 1 but also on the light derived from the light emitting diode area 2 so that the amount of carrier to be accumulated in the active layer 9 within the laser operation area 1 can be reduced.

By reference to Figures 1(A) to 1(C), a semiconductor laser device of a GaAl-AlGaAs system embodying this invention is described in greater detail below: On the (100) face of a p-GaAs substrate 6, an n-GaAs current blocking layer 7 having a thickness of 0.8 μm is grown by liquid phase epitaxy. On the n-GaAs current blocking layer 7, a striped channel, having a depth of 0.2 μm and widths of 14 μm inside of the device as shown in Figure 1(B) and of 7 μm near both facets 5 and 5' as shown in Figure 1(C), is formed by photolithography and a chemical etching technique. Then, a V-channel 1' corresponding to the laser operation area 1 and a V-channel 2' corresponding to the light emitting diode area 2 are formed within the striped channel by an etching technique in such a manner that both the V-channels 1' and 2' reach the p-GaAs substrate 6. It is to be understood that the ends of the V-channel 2' are not exposed from the facets 5 and 5' of the device. Then, on the n-GaAs current blocking layer 7 containing the striped channel and the V-channels, a p-$Ga_{0.5}Al_{0.5}As$ cladding layer 8, a p-$Ga_{0.85}Al_{0.15}As$ active layer 9, an n-$Ga_{0.5}Al_{0.5}As$ cladding layer 10 and an n-GaAs cap layer 11 are successively grown by liquid phase epitaxy to form a double heterostructure on the substrate 6 which has the superimposed double-striped channels thereon. The active layer 9 is formed into a plane, resulting in a gain-guided semiconductor laser device. The back face of the substrate 6 is polished to adjust the whole thickness of the device to approximately 100 μm. Then, the surface of the cap layer 11 and the back face of the substrate 6 are subjected to a vacuum evaporation treatment with metal materials of Au-Ge/Ni and Au-Zn, respectively, followed by heating at 450 °C to form an n-side electrode 12 made of an alloy of Au-Ge/Ni and a p-side electrode 13 made of an alloy of Au-Zn, respectively. The n-side electrode 12 is separated into two parts by a groove 4 which has a depth extending from the surface of the n-side electrode 12 to the n-cladding layer 10 at the portion corresponding to the center between the V-channels 1' and 2'. It was found experimentally that the electrical resistance between the two parts of the n-side electrode 12 exhibits several hundreds ohms, that is, these two parts of the n-side electrode 12 are electrically separated from each other. The facets 5 and 5' are formed by a cleavage, resulting in a semiconductor laser device unit having a resonator length of 250 μm. The V-channel 1' extends from the facet 5 to the facet 5'. The portion of the active layer 9 positioned between the V-channel 1' and the n-side electrode 12 constitutes the laser operation area 1. The V-channel 2' is positioned with a length of approximately 200 μm alongside the V-channel 1'. The position of the active layer 9 positioned between the V-channel 2' and the n-side electrode 12 constitutes the light emitting diode area 2. The laser operation area 1 and the light emitting diode area 2 are optically coupled by the common active layer 9. The resulting semiconductor laser device has a modulating function.

When electric current was injected into the device through the n-side electrode 12 and the p-side electrode 13, the electric current $I_1$ was allowed to flow into the laser operation area 1 resulting in laser oscillation. The oscillation threshold current $I_{th}$ was 45 mA and the oscillation wavelength $\lambda$ was 7750 Å in the case where the electric current $I_2$ was not allowed to flow into the light emitting diode area 2. When the electric current $I_2$ was allowed to flow into the light emitting diode area 2, the threshold current $I_{th}$ in the laser operation area 1 was reduced as the current $I_2$ increased (Figure 2(A)), whereas the oscillation wavelength $\lambda$ shifted to the long wavelength side as the current $I_2$ increased (Figure 2(B)). The spectrum width $\Delta f$ was reduced as the current $I_2$ increased (Figure 2(C)).

Moreover, it was found that the durability of the device at the time when the current $I_2$ is allowed to flow thereinto is significantly superior to that of the device at the time when the current $I_2$ is not allowed to flow thereinto.

In the semiconductor laser device in the above-mentioned Example 1, the n-side electrode 12 which is positioned at the upper portion of the active layer 9 is electrically separated into two parts by the groove 4, and moreover the electric current paths which are constituted by the channels 111 and 222 in the substrate 6 are electrically separated from each other, so that the currents $I_1$ and $I_2$ which are allowed to flow thereinto are separated from each other. Thus, when the current $I_1$ is allowed to flow into the laser operation area 1, the portion of the active layer 9 positioned above the V-channel 1' attains laser oscillation. When the current $I_2$ is independently

allowed to flow into the light emitting diode area 2, the carrier is recombined in the portion of the active layer 9 positioned above the V-channel 2', resulting in laser light. The laser light is transmitted to the laser operation area 1 within the active layer 9 to increase the optical density of the laser operation area 1, so that the laser oscillation conditions are changed to achieve modulation of the laser light.

(Example 2)

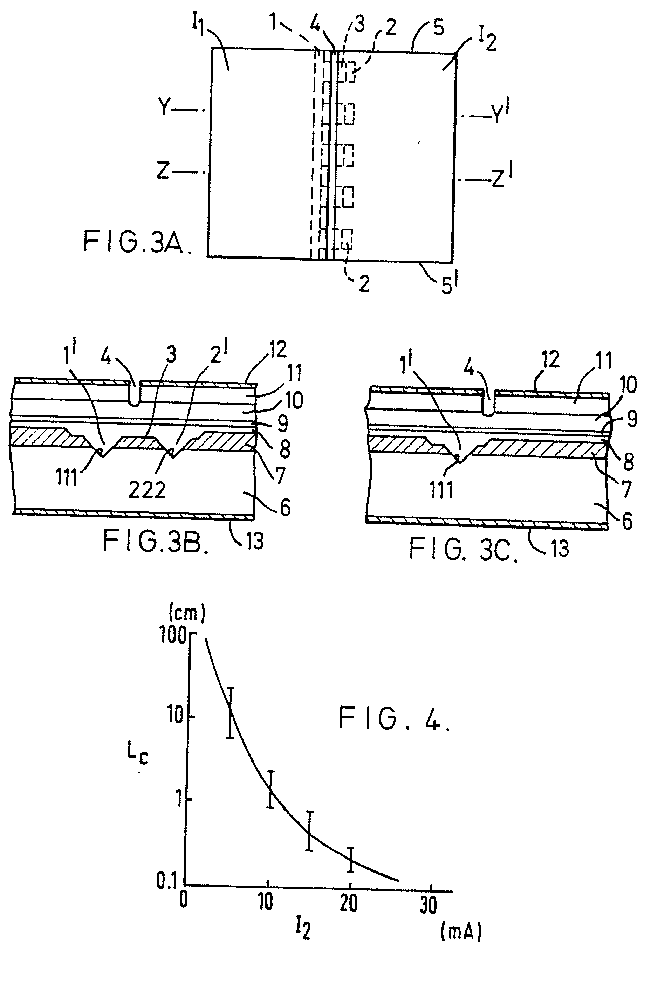

Figures 3(A), 3(B) and 3(C) show another VSIS (V-channeled substrate inner stripe) semiconductor laser device of a double heterostructure type of this invention, which comprises a striped laser operation area 1, an intermittent light-emitting-diode area 2 consisting of a plurality of parts disposed at regular intervals in a straight line parallel to the laser operation area 1, and an optical waveguide 3 which optically couples the light emitting diode area 2 with the laser operation area 1. The laser operation area 1 is electrically separated from the light emitting diode area 2 by a striped channel 4 which is formed along the laser operation area 1 on the side containing the electrode 12, so that the laser operation area 1 operates independently of the light emitting diode area 2 when electric currents $I_1$ and $I_2$ are injected into the device. The laser operation area 1 has cleavage facets 5 and 5', whereas the light emitting diode area 2 has no cleavage facets so that it cannot attain laser oscillation therefrom. Figure 3(B) shows a sectional view on line Y-Y' of the portion of the semiconductor laser device shown in Figure 3(A) which attains optical coupling between the laser operation area 1 and the light emitting diode area 2. Figure 3(C) shows a sectional view on line Z-Z' at the laser operation area 1 of the semiconductor laser device shown in Figure 3(A).

This semiconductor laser device is composed of a substrate 6 for multiple crystal growth, a current blocking layer 7 for the formation of a striped structure, a first cladding layer 8, an active layer 9, a second cladding layer 10, an ohmic contact layer 11, an n-side electrode 12 and a p-side electrode 13.

When electric current is injected into the device through the electrodes 12 and 13, it flows into the active layer 9 through channels 111 and 222, both of which are formed in the substrate 6. Since the active layer 9 is designed to be sandwiched between the heterojunctional interfaces of the cladding layers 8 and 10, it produces laser light based on the electric current (carrier) injected into the heterojunctions.

The current $I_2$ is allowed to flow into the light emitting diode area 2, resulting in laser light within the portion of the active layer 9 corresponding to each of the parts of the light emitting diode area 2, and at the same time the current $I_1$ is allowed to flow into the laser operation area 1, resulting in laser oscillation therein. The light produced in each of the parts of the light emitting diode area 2 is introduced into the portion of the active layer 9 corresponding to the laser operation area 1 through the optical waveguide 3. Thus, the portions of the active layer 9 which are irradiated with the lights from the light emitting diode area 2 and the other portions of the active layer 9 which are not irradiated with the lights from the light emitting diode area 2 are created alternatively in the direction of the striped laser operation area 1, resulting in a variety with regard to carrier density in the portion of the active layer 9 corresponding to the laser operation area 1 in the oscillation direction, that is, the carrier density is low in the portions which are irradiated with the lights from the light emitting diode area 2 whereas it is high for the portions which are not irradiated with the lights therefrom. The interaction between the lights and the carrier arises at each of the interfaces between the irradiated portions of the active layer 9 and the non-irradiated portions of the active layer 9, resulting in oscillation thereof. Therefore, laser light emitted from the facets 5 and 5' presents in multiple longitudinal modes each of which has a spectrum width of 1 Å or more. The coherent length thereof is as small as 1 cm or less. Moreover, the intensity of the lights produced in the light emitting diode area 2 can be regulated under the control of current $I_2$, so that the distribution of the carrier density of the portion of the active layer 9 corresponding to the laser operation area 1 in the oscillation direction can be regulated thereby allowing alternation of the coherent length.

By reference to Figures 3(A) to 3(C), a semiconductor laser device of a GaAs-AlGaAs system embodying this invention is described in greater detail below: On the (100) face of a p-GaAs substrate 6, an n-GaAs current blocking layer 7 having a thickness of 0.8 μm is grown by liquid phase epitaxy. On the n-GaAs current blocking layer 7, a striped channel, having a depth of 0.2 μm and widths of 14 μm at the portions having both the laser operation area 1 and the light emitting diode area 2 shown in Figure 3(B) and of 0.7 μm at the portions having the laser operation area 1 alone shown in Figure 3(C), is formed by photolithography and a chemical etching technique. Then, a continuous V-channel 1' corresponding to the laser operation area 1 and an intermittent V-channel 2' corresponding to the light emitting diode area 2 are formed within the striped channel by an etching technique in such a manner that both the V-channels 1' and 2' reach the p-GaAs substrate 6. The length of each of the parts of the V-channel 2' and each interval therebetween is 25 $\mu$m. Then, on the n-GaAs current blocking layer 7 containing the striped channel and the V-channels, a $p\text{-Ga}_{0.5}\text{Al}_{0.5}\text{As}$ cladding layer 8, a $p\text{-Ga}_{0.85}\text{Al}_{0.15}\text{As}$ active layer 9, an $n\text{-Ga}_{0.5}\text{Al}_{0.5}\text{As}$ cladding layer 10 and an n-GaAs cap layer 11 are successively grown by liquid phase epitaxy to form a double heterostructure on the substrate 6 having the superimposed double-striped channels thereon. The active layer 9 is formed into a plane, resulting in a gain-guided semiconductor laser device. The back face of the substrate 6 is polished to adjust the whole thickness of the device to approximately 100 $\mu$m. Then, the surface of the cap layer 11 and the back face of the substrate 6 are subjected to a vacuum evaporation treatment with metal materials of Au-Ge/Ni and Au-Zn, respectively, in the same manner as in Example 1, followed by the same heat-treatment as in Example 1 to form an n-side electrode 12 made of an alloy of Au-Ge-Ni and a p-side electrode 13 made of an alloy of Au-Zn, respectively. The n-side electrode 12 is separated into two parts by a groove 4 which has a depth ranging from the surface of the n-side electrode 12 to the n-cladding layer 10 at the portion corresponding to the center between the V-channels 1' and 2'. It was found experimentally that the electrical resistance between the two parts of the n-side electrode 12 exhibits several hundreds ohms, that is, these two parts of the n-side electrode 12 are electrically separated from each other. The facets 5 and 5' are likewise formed by cleavage, resulting in a semiconductor laser device unit having a resonator length of 250 $\mu$m. The V-channel 1' is in the range of the facet 5 to the facet 5'. The portion of the active layer 9 positioned between the V-channel 1' and the n-side electrode 12 constitutes the laser operation area 1. The portion of the active layer 9 positioned between the intermittent V-channel 2', which is disposed parallel to the V-channel 1' and each of the parts of which has a length of 25 $\mu m$, and the n-side electrode 12 constitutes the light emitting diode area 2 composed of plural parts. The laser operation area 1 and the light emitting diode area 2 are optically coupled by the common active layer 9. The resulting semiconductor laser device has a modulating function.

When electric current was injected into the device through the n-side electrode 12 and the p-side electrode 13, the current $I_1$ was allowed to flow into the laser operation area 1 resulting in laser oscillation. In the case where the current $I_2$ was not allowed to flow into the light emitting diode area 2, the oscillation threshold current Ith was 45 mA and the oscillation wavelength $\lambda$ was 7750 $\overset{\circ}{A}$. The laser oscillation took place in a single longitudinal mode with a spectrum width $\Delta\lambda$ of 0.001 $\overset{\circ}{A}$ or less and a coherent length Lc of 1 cm or more.

In the case where the current $I_2$ was allowed to flow into the light emitting diode area 2, the laser operation area 1 began laser oscillation in multiple longitudinal modes and the spectrum width $\Delta\lambda$ thereof became great gradually. For instance, when the current $I_2$ was 15 mA, the spectrum width $\Delta\lambda$ was approximately 1 $\overset{\circ}{A}$ which was extremely greater than that at the time when the current $I_2$ was zero, and the coherent length Lc was as small as approximately 6 mm. The dependence of the coherent length Lc on the current $I_2$ is shown in Figure 4, which indicates that the coherent length Lc is gradually reduced with an increase in the injection current $I_2$.

In the semiconductor laser device in the above-mentioned Example 2, the n-side electrode 12 positioned at the upper portion of the active layer 9 is electrically separated into two parts by the groove 4, and moreover, the electric current paths constituted by the channels 111 and 222 in the substrate 6 are electrically separated from each other, so that the currents $I_1$ and $I_2$ which are allowed to flow thereinto are separated from each other. Thus, when the current $I_1$ is allowed to flow into the laser operation area 1, the portion of the active layer 9 positioned above the V-channel 1' begins laser oscillation operation. When the current $I_2$ is allowed to flow into the light emitting diode area 2 independently of the current $I_1$, the recombination of carrier takes place in the portion of the active layer 9 positioned above the V-channel 2', resulting in light emissions therefrom. The lights are transmitted to the laser operation area 1 within the active layer 9 to increase the optical density in the limited portions of the active layer 9 corresponding to the laser operation area 1, so that the distribution of the varying optical density is created within the active layer 9 in the oscillation direction as described above, resulting in laser light in multiple longitudinal modes. The spectrum width and the coherent length can be varied. As mentioned above, the semiconductor laser device of this Example can produce laser light with a short coherent length by controlling the injection current, thereby allowing for the prevention of optical output noise due to backlight. Moreover, by biasing the injection current at the optimum value for each device, devices which produce laser light with a coherent length of **10** mm or less can be produced in a high yield.

Any of these semiconductor laser devices according to this invention are not limited to the GaAs-GaAlAs system, but they can be applied to semiconductor materials of an InP-InGaAsP system and/or other heterostructure laser devices. As the crystal growth method, not only liquid phase epitaxy but also metal-organic chemical vapor deposition, vapor phase epitaxy, molecular beam epitaxy, etc., can be employed.

It is understood that various other modifications will be apparent to and can be readily made by those skilled in the art without departing from the scope and spirit of this invention. Accordingly, it is not intended that the scope of the claims appended hereto be limited to the description as set forth herein, but rather that the claims be construed as encompassing all the features of patentable novelty which reside in the present invention, including all features which would be treated as equivalents thereof by those skilled in the art to which this invention pertains.

CLAIMS:-

1.    A semiconductor laser device comprising a striped laser-operation area (1), a light emitting diode area (2) disposed parallel to said striped laser-operation area (1), an optical waveguide (3) attaining an optical coupling between said laser-operation area (1) and said light emitting diode area (2), and a means (4, 12, 13, 111, 222) for independently supplying electric current to said laser-operation area (1) and said light emitting area (2).

2.    A semiconductor laser device according to claim 1, wherein said light emitting diode area (2) is continuous.

3.    A semiconductor laser device according to claim 1, wherein said light emitting diode area (2) is composed of plural parts arranged at regular intervals.

4.    A semiconductor laser device according to claim 1, 2 or 3, wherein said current supplying means are composed of an electrode (12), which is electrically separated into two parts, and electrical current paths (111, 222), which are disposed in a substrate (6) for multiple crystal growth.

5.    A semiconductor laser device according to claim 4, wherein said electrode (12) is separated into two parts by a groove (4) disposed at a position corresponding to the center between said laser operation area (1) and said light emitting diode area (2).

6.    A semiconductor laser device according to claim 4 or 5, wherein said electrical current paths (111, 222) are V-channels disposed in the portions of the substrate (6) corresponding to said laser operation area (1) and said light emitting diode area (2), respectively.

0183473

FIG.1A.

FIG.1B.

FIG.1C.

FIG.2A.

FIG.2B.

FIG.2C.

0183473

FIG.3A.

FIG.3B.

FIG. 3C.

FIG. 4.